# EUROPEAN PATENT SPECIFICATION

(11) **EP 0 226 461 B1**
(45) Date of publication and mention of the grant of the patent: **26.07.1995**
(21) Application number: 86309678.0
(22) Date of filing: 11.12.1986
(51) Int. Cl.: H01L 31/20, H01L 31/0392, H01L 31/08

(54) **Process for the preparation of an image-reading photosensor.**
Verfahren zur Herstellung eines Bildlesephotosensors.
Procédé de fabrication d'un photodétecteur lecteur d'images.

(30) Priority: 11.12.1985 JP 277002/85
(43) Date of publication of application: 24.06.1987
(73) Proprietor: CANON KABUSHIKI KAISHA, Tokyo (JP)
(72) Inventor: Hirooka, Masaaki, Ibaragi-ken (JP); Ishihara, Shunichi, Ebina-shi Kanagawa-ken (JP); Hanna, Junichi, Yokohama-shi Kanagawa-ken (JP); Shimizu, Isamu, Yokohama-shi Kanagawa-ken (JP)
(74) Representative: Beresford, Keith Denis Lewis

(56) References cited:
- EP-A- 0 226 462
- DE-A- 3 408 761
- DE-A- 3 429 899
- DE-A- 3 504 369
- FR-A- 2 549 461
- GB-A- 2 083 705
- US-A- 4 546 008

## Description

### FIELD OF THE INVENTION

This invention relates to a process for preparing an improved image-reading photosensor using an non-monocrystalline semiconducting material.

### BACKGROUND OF THE INVENTION

There have been proposed a number of image-reading photosensors for use as an element member in various information processing devices or copying machines.

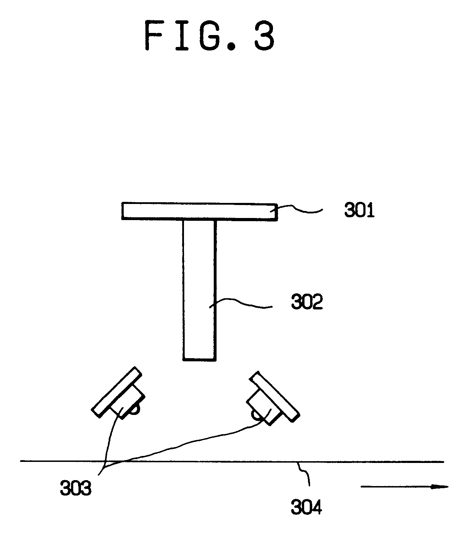

For instance, in the transmitter of facsimile or in copying machine, there is employed a photosensor having a function of reading images such as manuscript. A representative example in this respect wherein such image-reading photosensor is used is schematically illustrated in Figure 3, in which are shown image-reading photosensor 301, self-focusing light transmitting body 302 such as SELFOC LENS (registered trademark name of NIPPON GLASS SHEET CO., LTD.) being disposed downward to the photosensor, two light emitting diode (LED) arrays 303, 303 respectively being arranged beside the light transmitting body and a manuscript 304 to be read.

There are known a number of kinds for such photosensor. Among those known photosensors, ones that a non-monocrystalline semiconducting thin film such as amorphous semiconducting thin film or polycrystalline semiconducting thin film is used as the photoelectric conversion layer is commonly considered preferable in the view points that it has a wealth of practically applicable photoelectric conversive characteristics and that it can be easily sized to a large square measure.

The known image-reading photosensor using such non-monocrystalline semiconducting material as the photoelectric conversion layer is basically such that the photoelectric conversion layer composed of a non-monocrystalline semiconducting material is disposed on an electroinsulative substrate. And along with those image-reading photosensors, there have been proposed various methods for preparing the photoelectric conversion layer using vacuum evaporation technique, ion plating technique, reactive spattering technique, heat chemical vapor deposition technique, plasma chemical vapor deposition technique and light chemical vapor deposition technique. Among those methods, the method using plasma vapor deposition technique (hereinafter referred to as "plasma CVD method") has been generally recognized as being the most preferred and is currently used to manufacture the photoelectric conversion layer.

Processes for depositing non-monocrystalline semiconductor layers are described in JP-A-60-241222 (Canon KK), which in turn discloses a process of forming a silicon-containing deposited film by introducing a straight chain silane compound and a halogen compound into a deposition chamber. A substrate is placed in the chamber where the two compounds react, while heat energy is applied thereby to form said deposited film on a substrate.

However, for any of the known photoelectric conversion layers, even if it is an acceptable one that is obtained by plasma CVD method and that exhibits almost satisfactory characteristics, there still remain problems unsolved in satisfying totally the points for its characteristics, particularly electric and optical characteristics, photoconductive characteristics, deterioration resistance upon repeating use and use-environmental characteristics, other points for its homogeneity, reproducibility and mass-productivity and further points for its lasting stability and durability, which are required for the photoelectric conversion layer to be an immovable one.

The reasons are largely due to that the photoelectric conversion layer can not be easily prepared by a simple layer deposition procedure but much skill and ingenuity is required in the process operations in order to obtain a desirable photoelectric conversion layer while having due regards to the starting materials.

For example, in the case of forming a film composed of an amorphous silicon material (hereinafter referred to as "a-Si") according to heat chemical vapor deposition technique (hereinafter referred to as "CVD method"), after the gaseous material containing silicon atoms being diluted, appropriate impurities are introduced thereinto and the thermal decomposition of related materials is carried out at an elevated temperature between 500 and 650°C. Therefore, in order to obtain a desirable a-Si film by CVD method, precise process operation and control are required, and because of this the apparatus in which the process according to CVD method is practiced will be eventually complicated and costly. However, even in that case, it is extremely difficult to stably obtain a desirable homogeneous photoelectric conversion layer composed of an a-Si material being wealthy in practically applicable characteristics on an industrial scale.

Now, although the plasma CVD method is widely used nowadays as above mentioned, it is still accompanied with problems relating to process operations and to facility investment.

Regarding the former problems, the operation conditions to be employed under the plasma CVD method are much more complicated than the known CVD method, and it is extremely difficult to generalize them.

That is, there already exist a number of variations even in correlated parameters concerning the temperature of a substrate, the amount and the flow rate of gases to be introduced, the degree of pressure and the high frequency power for forming a layer, the structure of an electrode, the structure of a reaction chamber, the flow rate of gases to be exhausted, and the plasma generation system. Besides said parameters, there also exist other kinds of parameters. Under these circumstances, in order to obtain a desirable deposited film product it is required to choose precise parameters from a great number of varied parameters. And sometimes serious problems occur. For instance, because of the precisely chosen parameters, a plasma is apt to be in an unstable state which invites problems in a deposited film to be formed.

And for the apparatus in which the process using the plasma CVD method is practiced, its structure will be eventually complicated since the parameters to be employed are precisely chosen as above stated. Whenever the scale or the kind of the apparatus to be used is modified or changed, the apparatus must be so structured as to cope with the precisely chosen parameters.

In this regard, even if a desirable deposited film should be fortuitously mass-produced, the film product becomes unavoidably costly because (1) a heavy investment is firstly necessitated to set up a particularly appropriate apparatus therefor ; (2) a number of process operation parameters even for such apparatus still exist and the relevant parameters must be precisely chosen from the existing various parameters for the mass-production of such film. In accordance with such precisely chosen parameters, the process must then be carefully practiced.

Against this background, an image-reading photosensor has become diversified nowadays. And there is an increased demand to stably provide a relatively inexpensive image-reading photosensor having a photoelectric conversion layer with a normal square measure or a large square measure being composed of an a-Si material which has a relevant uniformity and many applicable characteristics and which is suited for the use purpose and the application object.

Consequently there is an earnest desire to develop an appropriate method and apparatus to satisfactorily meet the above demand.

Likewise, there is a similar situation which exists with respect to other kinds of non-monocrystalline semiconducting layers to constitute the photoelectric conversion layer of an image-reading photosensor, for example, those composed fo an a-Si material containing at least one kind selected from oxygen atoms, carbon atoms and nitrogen atoms.

### SUMMARY OF THE INVENTION

The present inventors have conducted extensive studies in order to solve the problems in the aforementioned known methods and in order to develop a new process for effectively and simply preparing an improved image-reading photosensor having a desirable photoelectric conversion layer composed of a non-crystalline semiconducting material, which has a wealth of practically applicable characteristics, without depending upon any known method and which meets the above-mentioned demands.

As a result, the present inventors finally have found a process that enables one to efficiently and stably prepare said image-reading photosensor in simplified particular procedures as detailed below.

The invention provides a process for preparing an image-reading photosensor having a substrate, an insulating film, a photoelectric conversion layer comprising a film composed of a non-single crystalline semiconductor material, an ohmic contact film and an electrode electrically connected to the photoelectric conversion layer via said ohmic contact film, wherein each of said films is formed by:
(a) supporting said substrate at a predetermined position in a film-forming space of a CVD vacuum chamber provided with a plurality of gas transportation conduits, wherein said gas transportation conduits comprises concentrically arranged pipes, the ends of which are arranged at a position facing the surface of the substrate at a distance of between 5 mm and 15 cm,
(b) supplying a first gaseous substance through one of said plurality of gas transportation conduits into said film-forming space, said first gaseous substance, containing an element which is a constituent of the film, which is essentially incapable of contributing to the formation of said film in its original energy state,
(c) separately supplying a second gaseous substance through another of said plurality of gas transportation conduits into said film-forming space, said second gaseous substance being capable of oxidising said first gaseous substance and which comprises molecules selected from one or more of air, O₂, O₃, N₂O, N₂O₃, N₂O₄, H₂O₂, F₂, Cℓ₂, Br₂, I₂, nascent fluorine, nascent chlorine and nascent iodine, and
(d) chemically reacting said first and second gaseous substances in the absence of a plasma in a reaction region (B′) adjacent the surface of the substrate while maintaining the substrate at an elevated temperature, so that precursors are generated which include excited precursors and so that at least one of the precursors becomes deposited on the substrate to form the film.

By this process, there can be obtained a desirable photoelectric conversion layer in a simple non-plasma process, and therefore without having any influence of plasma etching or any problem due to abnormal discharge actions since the process does not depend upon the conventional plasma CVD method using a gaseous plasma formed by subjecting the starting gaseous materials to the action of a discharge energy.

It is noted that EP-A-0234094 (Canon Kabushiki Kaisha), which belongs to the state of the art according to Article 54(3) EPC, discloses a process similar to that set forth above, but without formation of an ohmic contact layer by the same process.

In addition, use of the invention can bring some or all of the following advantages; a desirable photoelectric conversion layer for an image-reading photosensor having a uniform thickness and a desirable homogeneity may be effectively formed at an imporved film forming rate in simple procedures without consumption of so much energy as in the conventional plasma CVD method; the operation parameters for preparing a photoelectric conversion layer for an image-reading photosensor may be largely simplified; an improved image-reading photosensor having such desirable photoelectric conversion layer or if necessary, of a large square measure may be mass-produced on an industrial scale to thereby reduce the cost of a product; and such a heavy inventment as much for the apparatus in the conventional plasma CVD method is not necessitated even in the case of setting up a particularly appropriate apparatus to practice the process of this invention.

These and other features of this invention will become apparent by reading the following descriptions of preferred embodiments according to this invention while referring to the accompanying drawings.

### BRIEF DESCRIPTION OF THE DRAWINGS

Figure 1(A) through Figure 1(E) are schematic portion views for illustrating representative embodiments of an image-reading photosensor, in which
   Figure 1(A) is a cross-sectional view of a first representative embodiment of an image-reading photosensor;
   Figure 1(B) is a perspective view for illustrating the whole body of the embodiment as shown in Figure 1(A);
   Figure 1(C) is a cross-sectional portion view of a second representative embodiment of the image-reading photosensor;
   Figure 1(D) is a cross-sectional portion view of a third representative embodiment of the image-reading photosensor;
   Figure 1(E) is a cross-sectional portion view of a fourth representative embodiment of the image-reading photosensor;
Figure 2 is a schematic explanatory view of a fabrication apparatus as an example of the apparatus for preparing the image-reading photosensor; and
Figure 3 is a schematic explanatory view of an example wherein an image-reading photosensor is used.

### DETAILED DESCRIPTION OF THE EMBODIMENTS

The inventors have developed a process in which
(i) a substance which can be a constituent for forming a photoelectric conversion layer but which does not or can hardly contribute to form said layer as long as it remains in its original energy state and (ii) another substance which can chemically react with the substance (i) to electronically oxidize it (which means that the atom, ion or molecule of the substance loses an electron, namely the oxidation number is increased) were selected, and the two substances in gaseous state were separately introduced through respective transporting passage into a film forming space wherein a substrate for the image-reading photosensor being maintained at about 300°C is placed thereby letting the two substances collided and contacted to occur a chemically mutual reaction among the two substances in the space positioned above the substrate in the film forming space.

As a result, there was formed a homogeneous deposited film with an uniform thickness without accompaniment of any solid particle on the substrate. And it was found that the resulting deposited film has a wealth of electric and optical properties and is uniformly accompanied with an excellent photoelectric conversion function.

When an image-reading photosensor was tried to prepare in accordance with the above procedures, there was obtained a desirable image-reading photosensor being wealthy in practical applicable characteristics such as electric and optical characteristics, deterioration resistance upon repeating use and use-environmental characteristics and having an excellent photoelectric conversion function. As a result, it was confirmed that this method is of a sufficient repeatability.

The starting substance to be used as the foregoing substance contributing to form a photoelectric conversion layer of the image-reading photosensor of this invention (hereinafter referred to as the term "starting substance A") means a substance which can be a constituent for forming said layer but which does not or hardly contribute to form said layer as long as it remains in its original energy state, as previously mentioned. But it is required for the starting substance to generate plural kinds of precursors containing excited precursors when it is chemically contacted with the foregoing electronically oxidizing agent.

And the starting substance A is chosen appropriately in accordance with the kind, the expecting characteristics to be brought about, and/or the using purpose of the objective photoelectric conversion layer.

For the starting substance A, any gaseous, liquid or solid substance may be used as long as it meets the above condition and it can be easily in gaseous state when chemically contacted with said oxidizing agent.

When a liquid or solid substance is employed as the starting substance A, it is bubbled using an inert gas such as Ar, He, N₂ or H₂ and, if necessary, while being heated to thereby cause generating a gas of the substance, which is then introduced into a film forming space.

For the foregoing electronically oxidizing agent, a gaseous substance is used. There is also a requirement for the oxidizing agent. That is, the oxidizing agent must be such that has a property to easily cause an excitation for the starting substance A due to the electronical oxidization action of the oxidizing agent from a chemical contact between the two substances.

Therefore, usable as such oxidizing agent are, for example, oxygen gases such as air, oxygen (O₂) and ozone (O₃), oxygen atom containing substances or nitrogen atom containing substances such as dinitrogen oxide (N₂O), dinitrogen trioxide (N₂O₃) and dinitrogen tetraoxide (N₂O₄) peroxides such as hydrogen peroxide (H₂O₂), halogen gases such as F₂, Cl₂, Br₂ and I₂, and others than these, nascent state halogens such as nascent state fluorine, chlorine and iodine.

In the case where a liquid or solid substance is chosen as the oxidizing agent, it is bubbled using an inert gas such as Ar, He, N₂ or H₂ and if necessary, while being heated to thereby cause generating a gas of the substance, which is then introduced into the film forming space in the same was as in the case of the starting substance A.

The aforementioned starting substance A and the aforementioned electronically oxidizing agent are introduced separately through respective transporting passage into a film forming space with an appropriate flow rate and under an appropriate pressure condition and collided each other to cause chemical contacts between the two substances thereby inviting the starting substance to be electronically oxidized with the oxidizing agent to effectively generate plural kinds of precursors containing excited precursors. And at least one kind of those resulting precursors is directed to form a deposited film to be the photoelectric conversion layer of an image-reading photosensor on a substrate placed while being maintained at a predetermined temperature in the film forming space.

In the above film forming process, the excited precursor generated therein becomes other kind precursor or other kind excited precursor through successive decomposition or chemical reaction, or it sometimes liberates an energy. However the excited precursor comes to the result to touch the surface of the substrate placed while being maintained at a predetermined temperature in the film forming space and bring about the formation of a deposited film having a three dimensional network structure on the substrate. In this system, the energy level of the excited precursor generated as a result of the chemical contact between the starting substance A and the oxidizing agent is preferred to be either such that is transited to a lower energy level or such that is accompanied with an emission during the process when the excited precursor be changed into other kind chemical species.

Because of the generation of plural kinds of precursors containing such excited precursor as being accompanied with an emission for its energy transition, the formation process of the photoelectric conversion layer of the image-reading photosensor is effectively proceeded with a lower consumption of power energy to thereby obtain an improved image-reading photosensor provided with a desirable photoelectric conversion layer with an uniform thickness and a desirable homogeneity and which has an excellent photoelectric conversion function.

A representative embodiment of the image-reading photosensor manufactured in accordance with this invention will be explained more specifically referring to the drawing 1D. The description is not intended to limit the scope of the invention.

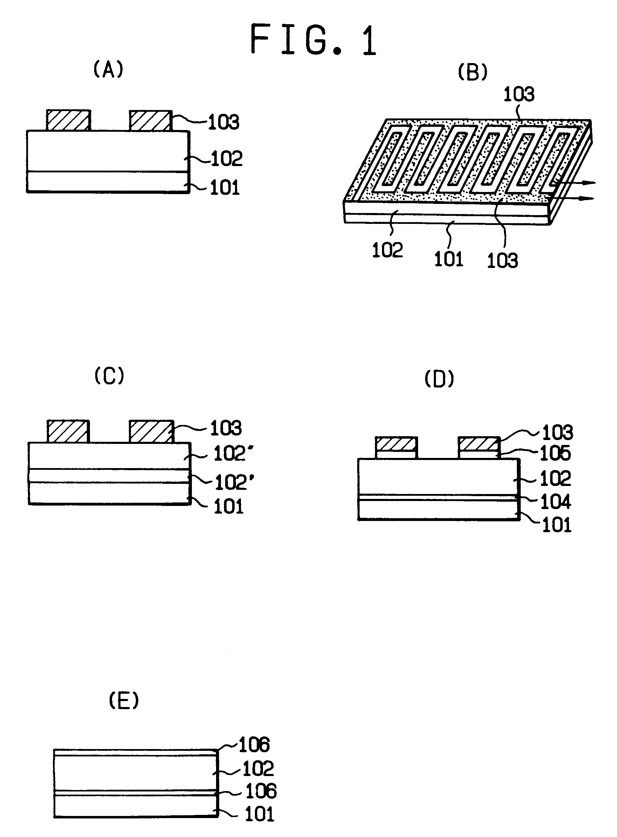

The image-reading photosensors as shown in Figures 1(A), 1(C) and 1(D) are of the type that the radiation of a light is conducted from the side of the substrate, in which are shown substrate 101, photoelectric conversion layer 102, constituting layers of the photoelectric conversion layer 102' and 102", gap type electrode 103, under coat layer 104 and ohmic contact layer 105.

The image-reading photosensor as shown in Figure 1(E) is of the type that the radiation of a light is conducted from the side of the substrate and also from the side of the photoelectric conversion layer, in which are shown transparent substrate 101, photoelectric conversion layer 102 and transparent electrode 106.

In any of the above image-reading photosensors, the substrate 101 is electrically insulative.

The electrically insulative substrate can include, for example, film or sheet of synthetic resins such as polyester, polyethylene, polycarbonate, cellulose acetate, polypropylene, polyvinyl chloride, polyvinylidene chloride, polystyrene, and polyamide; glass, ceramics, and paper.

The thickness of the substrate is properly determined so that the image-reading photosensor as desired can be obtained. However, the thickness is usually greater than 10 »m in view of the fabrication and handling or mechanical strength of the substrate.

The photoelectric conversion layer comprises a semi-conductive non-monocrystalline material, preferably, an amorphous material containing silicon atoms (Si) as the main constituent, and if necessary at least one of hydrogen atoms (H) and halogen atoms (X) (hereinafter referred to as "a-Si (H, X)"). Also, optionally, containing electroconductive substances.

The halogen atom (X) includes, specifically, fluorine, chlorine, bromine and iodine, fluorine and chlorine being particularly preferred. The amount of the hydrogen atoms (H) , the amount of the halogen atoms (X) or the sum of the amounts for the hydrogen atoms and the halogen atoms (H+X) contained in the photoelectric conversion layer 102 is usually from 1 to 40 atm% and, preferably, from 5 to 30 atm%.

And in the case when only the halogen atom (X) is contained in the photoelectric conversion layer 102, its amount is preferably at least 0.001 atomic%, more preferably, 0.01 atomic% and most preferably, 0.1 atomic%.

It is possible to make the photoelectric conversion layer 102 either n-type or p-type by appropriately doping the layer with a n-type impurity or a p-type impurity while controlling the impurity amount when the layer is being formed.

Usable as impurities are, for example, elements of Group IIIA of the Periodic Table such as B, Al, Ga, In, Tl and the like for the p-type impurity, and elements of Group VA of the Periodic Table such as N, P, As, Sb, Bi and the like for the n-type impurity. Of these impurities, B, Ga, P and Sb are the most appropriate.

In order for the photoelectric conversion layer 102 to have a desired type conductivity, the amount of an impurity with which the layer 102 is doped may be determined appropriately depending upon its desired electrical and optical characteristics.

For the impurities of Group IIIA of the Periodic Table, the amount used will be less than 3 x 10⁻² atomic %, and in the case of the impurities of Group VA of the Periodic Table, the amount used will be less than 5 x 10⁻³ atomic %.

In addition, the photoelectric conversion layer 102 of the image-reading photosensor according to this invention may be of a multi-layered structure possessing an optical multi-band gap.

Figure 1(C) illustrates a typical embodiment in that case, in which the photoelectric conversion layer is composed of layer 102′ and layer 102˝.

The formation of such multi-layered photoelectric conversion layer possessing optical multi-band gaps may be carried out by introducing at least one kind selected from oxygen atoms (O), carbon atoms (C), nitrogen atoms (N), germanium atoms (Ge) and tin atoms (Sn) as the band gap adjusting element into the layer during its formation process.

That is, in one example of the embodiment shown in Figure 1(C), the layer 102′ is composed of a-Si (H, X) containing at least one kind selected from oxygen atoms (O), carbon atoms (C), nitrogen atoms (N), germanium atoms (Ge) and tin atoms (Sn) [hereinafter referred to as "a-Si (O, C, N, Ge, Sn) (H, X)"] and the layer 102˝ is composed of a-Si (H, X) not containing any of the above elements or containing one or more elements different from those contained in the layer 102′ or containing the same kind elements as those contained in the layer 102′.

The aforesaid multi-layered photoelectric conversion layer possessing an optical multi-band gap may be also formed by varying the film formation rate of a deposited film to be formed on the substrate. For example, the formation of the layer 102′ is carried out at a high film formation rate then the formation of the layer 102˝ is carried out at a low film formation rate.

In an case of the embodiments of the image-reading photosensor shown in Figures 1(A), 1(C), 1(D), and 1(E), the thickness of the photoelectric conversion layer is selected depending upon the requirements for the photoelectric conversion layer of the image-reading photosensor to be prepared. In general, the thickness of the photoelectric conversion layer is preferably 0.05 to 100 »m, more preferably, 0.1 to 50 »m, and most preferably, 0.5 to 30 »m.

In the image-reading photosensor manufactured in accordance with the process of this invention an insulating film 104 is disposed between the substrate 101 and the photoelectric conversion layer 102 in the way as shown in the embodiment of Figure 1(D). As insulating film, there can be mentioned a layer composed of a-Si(H,X) containing nitrogen atoms namely a-SiN(H,X) or Si₃N₄.

The gap type electrode 103 in the image-reading photosensor according to this invention is composed of a conductive material. And the electrode is preferred to be such that conducts an ohmic contact with the photoelectric conversion layer 102.

As the conductive material to bring about said ohmic contact, a metal having a lower work function such as Al and In or a lower resistive film composed of a-Si(H,X) doped with a large amount (usually more than 100 ppm) of an element of Group V of Periodic Table such as P or As may be used in the case of using a non-doped film composed of a-Si(H,X) as the photoelectric conversion layer. However, as an alternative, as shown in Figure 1(D), there can be disposed an ohmic contact layer 105 composed of a-Si(H,X) doped with a large amount of an element of Group V between the electrode 103 composed of a conductive material such as Al and the photoelectric conversion layer 102.

In addition, in the case of the image-reading photosensor shown in Figure 1(E) for which the radiation of a light is conducted from the side of the substrate 101 and also from the side of the photoelectric conversion layer 102, a transparent electrode composed of In₂O₃ is disposed between the transparent substrate 101 and the photoelectric conversion layer 102 and also on the photoelectric conversion layer 102.

In any case of the embodiments of the image-reading photosensor as shown in Figures 1(A), 1(C), 1(D) and 1(E), there can be disposed an insulative layer (not shown) onto the top surface. Usable as the constituent material for the insulative layer are, for example, a-Si(H,X) containing nitrogen atoms, insulative inorganic materials such as Si₃N₄ and insulative organic resins.

And it is also possible to dispose a gap type electrode on the substrate firstly then a photoelectric conversion layer thereon. (not shown)

For the preparation of such image-reading photosensor not only the photoelectric conversion layer 102 containing a-Si(H,X) as the main constituent but also the under coat layer 104 comprising a-SiN(H,X) and the insulative layer comprising a-SiN(H,X) can be formed respectively in accordance with the foregoing procedures. And in the formation of these layers, there can be obtained a desirable layer having many practically applicable characteristics to meet the requirements for the layer by selecting the proper kind of the starting substance A and that of the electronically oxidizing agent and an appropriate combination thereof and introducing them separately into the film forming space as previously mentioned.

That is, in the case of forming a relevant layer composed of a-Si(H,X) , a gaseous or gasifiable silicon hydride (silane) such as SiH₄, Si₂H₆,Si₃H₈ and Si₄H₁₀ or a gaseous or gasifiable halogen-substituted silicon hydride such as SiH₃Cl, SiH₃F and SiH₃Br may be preferably used as the starting substance A.

And as the electronically oxidizing agent in that case, a halogen gas such as F₂, Cl₂, Br₂ and I₂ or a nascent state halogen such as nascent state fluorine, chlorine and iodine may be preferably used. And among these substances, F₂ gas and Cl₂ gas are most preferred.

And in the case of forming a relevant layer composed of a-Si(H,X) containing p-type impurities, an appropriate starting substance to impart p-type impurities is used in addition to the foregoing two substances.

Usable as such starting substance are, for example, compounds containing the Group III atoms as their constituents such as B₂H₆, B₄H₁₀, B₅H₉, B₆H₁₀, B₆H₁₂, Al(CH₃)₃, Al(C₂H₅)₃, Ga(CH₃)₃ and In(CH₃)₃. Among these compounds B₂H₆ is most preferred.

Further in the case of forming a relevant layer composed of a-Si(H,X) containing n-type impurities, an appropriate starting substance to impart such n-type impurities is used in addition to the foregoing two substances.

Usable as such starting substance are, for example, compounds containing Group V elements as their constituents such as PH₃, P₂H₄, AsH₃, SbH₃ and BiH₃. Among these compounds, PH₃ is most preferred.

In the case of forming a relevant layer composed of a-Si(O, C, N, Ge, Sn) (H, X), there is used a gaseous or gasifiable compound containing nitrogen atoms as its constituent such as N₂, NH₃, H₂NNH₂, HN₃ or NH₄N₃, or a gaseous or gasifiable hydrocarbon compound such as CH₄, C₂H₂, C₂H₄, C₂H₆, C₃H₆ or C₃H₈, or a gaseous or gasifiable germane such as G₂H₄, Ge₂H₆, Ge₃H₈, Ge₄H₁₀ or Ge₅H₁₂, or SnH₄ in stead of part of the foregoing silane or halogen-substituted silicon hydride as the starting substance A. And as the electronically oxidizing agent, at least one kind of oxygen or gas or of nitrogen gas selected from O₂, O₃, N₂O, N₂O₃ and N₂O₄.

In the process for preparing an improved image-reading photosensor according to this invention, the conditions upon forming the photoelectric conversion layer and other layers, for example, the combination of the starting substance A with the electronically oxidizing agent, their mixing ratios, the gas pressure upon mixing those substances in the film forming space, their gas flow rates, the internal pressure upon forming a layer on the substrate, the carrier gas flow rate, the temperature of the substrate and the flow type of each gaseous substance when introduced into the film forming space are important factors for obtaining the image-reading photosensor having desired characteristics and they are appropriately selected while considering the functions of the layer to be formed. Further, since these layer forming conditions are organically correlated and may be varied depending upon the kind and the amount of each of the atoms contained in the layer, the conditions are to be determined taking these relationships into consideration.

The volume ratio of the starting substance A to the electronically oxidizing agent on the basis of the flow ratio is preferably 1/100 to 100/1, and more preferably, 1/50 to 50/1.

As for the volume ratio of the gaseous substance containing the p-type impurity or the n-type impurity as its constituent to the starting substance A on the basis of the flow ratio is preferably 1/10⁶ to 1/10, more preferably, 1/10⁵ to 1/20, and most preferably, 1/10⁵ to 1/50.

The gas pressure in the film forming space when the starting substance A is mixed with the electronically oxidizing agent is preferred to be higher in order to facilitate their chemical contact. But it is necessary to be determined with due regard to their reactivities. Therefore, it is preferably 1 x 10⁻⁷ to 10 atmospheric pressure, and more preferably, 1 x 10⁻⁶ to 3 atmospheric pressure.

The internal pressure in the film forming space, namely, the pressure of the inner space wherein the substrate is placed is appropriately determined with due regard to the excited precursors to be generated in the above inner space and to the conditions which let those precursors derived from the excited precursors to become effective in forming a deposited layer.

The internal pressure in the film forming space in the case where the reaction region is open-connected to the film forming region can be adjusted with the use of a differential exhausting means or a large scale exhausting device while having due regard to the correlated conditions relating to the introducing pressure and the introducing flow rate for each of the gaseous starting substance A, the electronically oxidizing agent and the gaseous starting substance to impart a p-type or n-type impurity when they are introduced into the reaction region of the film forming space.

In the case where the conductance of the connecting part between the reaction region and the film forming region is relatively small, the internal pressure in the film forming region can be adjusted by controlling the amount of the exhausting gas by operating an exhausting device being connected to the film forming region.

Further in the case where the reaction region and the film forming region are united and they are not structurally separated, it is desirable to conduct the gas exhaustion with a differential gas exhausting means or with the use of a large scale gas exhausting device.

As above mentioned, the internal pressure in the film forming space is determined while having a due regard on the correlative pressure conditions in introducing the starting substance A, the electronically oxidizing agent and the substance to impart p-type or n-type impurities into the film forming space. However, in general, the internal pressure is preferably, 0.13 to 1.3 x 10⁴ Pa (0.001 to 100 Torr), more preferably, 1.3 to 3.99 x 10³ Pa (0.01 to 30 Torr), and most preferably, 6.67 to 1.3 x 10³ Pa (0.05 to 10 Torr).

As for the form of the gas flow into the film forming space for each of the foregoing substances, they are appropriately designed with due regard to the geometrical arrangement of the gas flow inlet, the substrate and the gas flow outlet so that the starting substance A, the electronically oxidizing agent and the substance to impart p-type or n-type impurities are effectively introduced into and homogeneously and well mixed in the predetermined region of the film forming space to generate desired precursors and to bring about the effective formation of a deposited film on the substrate.

The temperature of the substrate upon forming a deposited film thereon is properly determined according to the kind of a gaseous substance to be employed and also to the kind of a deposited film to be formed.

That is, in the case of forming a deposited film composed of an amorphous material, it is preferably room temperature to 450°C, and more preferably, 50 to 450°C. Specifically, in the case of forming a deposited film composed of a-Si(H,X) having a desired photoelectric conversive characteristic, it is preferred to be 70 to 350°C. And, in the case of forming a deposited film composed of a polycrystalline material, it is preferably 200 to 650°C, and more preferably, 300 to 600°C.

The atmospheric temperature in the film forming space is properly determined with due regard to the temperature of the substrate so that desired precursors are effectively generated, and those precursors as generated and other precursors derived from the former precursors are not changed into undesired things during the film forming process in the film forming space.

There will now be described the following Examples 1 to 2, which are provided here for illustrative purposes only, and are not intended to limit the scope of this invention.

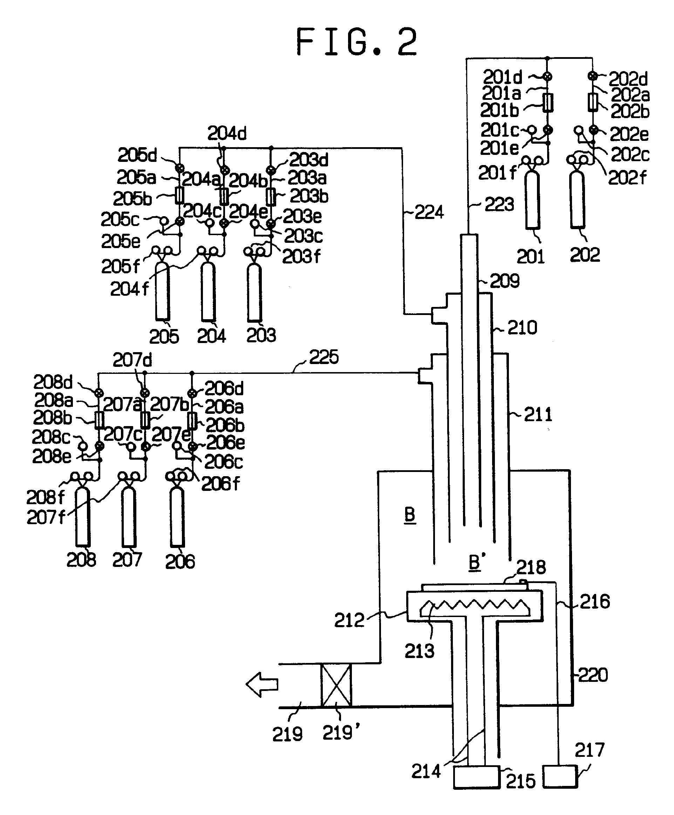

In each of the examples, the corresponding layer of an image-reading photosensor is formed by using the fabrication apparatus as shown in Figure 2.

The fabrication apparatus as shown in Figure 2 comprises a vacuum chamber having a film forming space with which a gas supplying system and a gas exhausting system are provided.

In Figure 2, there are shown gas reservoirs 201 through 208, gas supplying pipeways 201a through 208a respectively extended from the gas reservoirs 201 through 208, mass flow controllers 201b through 208b being placed respectively on the gas supplying pipe ways 201a through 208a for controlling the flow rate of a gas from each of the gas reservoirs, pressure gages 201c through 208c, main valves 201d through 208d, sub-valves 201e through 208e and gas reservoir pressure gases 201f through 208f.

With vacuum chamber 220, there are provided first gas supplying conduit 209, second gas supplying conduit 210 and third gas supplying conduit 211 which are extended into a film forming space B of the vacuum chamber through its upper wall and ended leaving a space B′ sufficient enough to form a reaction region between a substrate 218 to be placed therein.

As for the first, second and third gas supplying conduits 209, 210 and 211, it is used a concentric triple conduit having a first circular space as the first gas supplying conduit 209, a second circular space as the second gas supplying conduit 210 and a cylindrical space positioned in the middle as the third gas supplying conduit 211.

And the end portion of the concentric triplicate conduit in the film forming space B is desired to be in such a form as showing as inwardly cut surface at an external appearance with leaving a round space B′ to act as the reaction region. And with the inwardly cut surface the outlet of each of the gas supplying conduits 209, 210 and 211 is downwardly opened.

In an alternative, the end portion of the concentric triplicate conduit may be structured in such a way that the outlet of the third gas supplying conduit 211 in the cylindrical form is positioned in the innermost recess and the remaining end portion composed of the outlets of the first and second gas supplying conduits is in the diagonally cut surface form so as to leave a space in the form of conic trapezoid B′ to act as the reaction region.

To the first gas supplying conduit 209, a gas feeding pipe 223 for the gas from the gas reservoirs 201 and 202 is connected. To the second gas supplying conduit 210, a gas feeding pipe 224 for the gas from the gas reservoirs 203, 204 and 205 is connected. And to the third gas supplying conduit, a gas feeding pipe 225 for the gas from the gas reservoirs 206, 207 and 208 is connected.

With the bottom part of the vacuum chamber 220 there is provided an exhausting pipe 219 having a vacuum valve 219′. The exhausting pipe 219 is connected to a exhausting device (not shown). The air or gas in the gas feeding pipes 223, 224 and 225, the gas supplying conduits 209, 210 and 211 and the vacuum chamber 220 can be evacuated by operating the exhausting device through the exhausting pipe 219.

The substrate 218 is placed on substrate holder 212 which can be shifted upwardly or downwardly with a driving means (not shown), and in which a heater for the substrate 213 is installed. The heater 213 is electrically connected to an electric power source 215 through leading wires 214, 214. In order to measure the temperature of the substrate 218, there is provided a thermocouple 216 being electrically connected to a temperature indicator 217 with the vacuum chamber 220.

The position of the substrate 218 upon forming a deposited film thereon is appropriated adjusted by shifting the substrate holder 212 so that there is left a desired distance between the surface of the substrate 218 and the outlets of the gas supplying conduits 209, 210 and 211.

Such desired distance is determined properly depending upon the kind of a deposited film to be formed, its characteristics as expected, the flow rate of a gas to be employed, the internal pressure in the vacuum chamber and the like.

According to the process of the invention this distance is between 5 mm and 15 cm.

The heater 213 is operated usually to heat the substrate 218 to an appropriate temperature or to conduct a provisional heat treatment on the substrate. However, the heater 213 can be used to anneal the deposited film formed on the substrate.

### Example 1

An image-reading photosensor of the type as shown in Figure 1(A) was prepared using the apparatus as shown in Figure 2.

In this example, the distance between the outlet of the gas supplying conduit 211 of the concentric triplicate conduit and the surface of the substrate 218 was adjusted to be 3 cm.

As the substrate 218, a glass plate of 1 mm in thickness and 10 cm x 5 cm in size was used. The glass plate was treated with a 1.0% aqueous solution of NaOH, washed with distilled water then air-dried.

This glass plate was firmly disposed to the surface of the substrate holder 212 placed at the predetermined position in the vacuum chamber 220. The air in the film forming space B was evacuated by opening the vacuum valve 219′ to bring the space to a vacuum of about 1.3 x 10⁻³ Pa (10⁻⁵ Torr). Then, the heater 213 was actuated to heat uniformly the glass plate (substrate) 218 to 250°C, and the plate was maintained at this temperature.

In parallel, SiH₄ gas from the reservoir 201 was fed into the reaction region B′ through the gas supplying conduit 209 at a flow rate of 1.67 x 10⁻⁷ m³ S⁻¹ (10 SCCM). At the same time, F₂ gas from the reservoir 206 and He gas from the reservoir 207 were fed into the reaction region respectively at a flow rate of 3.3 x 10⁻⁸ m³ S⁻¹ (2 SCCM) and at a flow rate of 6.67 x 10⁻⁷ m³ S⁻¹ (40 SCCM) through the gas supplying conduit 211. After the flow amount of the gases became stable, the vacuum in the vacuum chamber 220 was brought to and maintained at about 106.7 Pa (0.8 Torr) by regulating the vacuum valve 219′. Wherein, there was observed a strong blue luminescence throughout the reaction region B′ namely all over the confluent part of the gas from the gas supplying conduit 209 and the gas from the gas supplying conduit 211 and the surface of the glass plate 218.

After 2 hours, it was found that an a-Si:H:F film of about 1.0 »m in thickness was uniformly on the glass plate 218.

The feedings of all the gases were terminated by closing the corresponding valves, the heater was switched off, and the vacuum atmosphere in the vacuum chamber was released to atmospheric pressure by opening the vacuum valve 219′.

After the glass plate 218 being cooled to room temperature, it was taken out from the vacuum chamber 220. Then the glass plate was placed in another vacuum chamber (not shown) and a comb line Al electrode of about 0.05 »m (500 Å) in thickness, 2.5 cm in gap length and 0.2 mm in gap interval was formed on the surface of the film deposted on the glass plate in accordance with the known vacuum deposition method to obtain an objective image-reading photosensor.

An electric current was measured by impressing a voltage on the resulting photosensor.

As a result, it was found that the ratio of electric current under light irradiation to electric current under a dark condition was 1 x 10^{3.8}. There was no change in this numerical value, even after light irradiation for 24 hours.

In a comparative example, the same procedures of Example 1 were repeated except that the known plasma CVD method was employed to form a-Si:H:F film on the glass plate, to thereby obtain an image-reading photosensor.

This comparative photosensor examined by the same procedure as mentioned above.

As a result, it was found that the ratio of electric current under light irradiation to that under a dark condition for the comparative photosensor was 1 x 10^{3.4} at the beginning, but decreased to 1 x 10^{2.3} after light irradiation for 24 hours.

### Example 2

An image-reading photosensor of the type as shown in Figure 1(D) which comprises a glass plate (substrate), an under coat layer composed of an a-SiN:H:F, a photoelectric conversion layer composed of a-Si:H:F, an ohmic contact layer composed an a-Si:H:F:P doped with phosphorus atoms (P), and an aluminum electrode.

In this example, the distance between the outlet of the gas supplying conduit 211 of the concentric triplicate conduit and the surface of the substrate 218 was adjusted to be 4 cm.

As the substrate 218, a glass plate of 1 mm in thickness and 10 cm x 5 cm in size was used. The glass plate was treated with a 1.0% aqueous solution of NaOH, washed with distilled water then air-dried. This glass plate was firmly disposed to the surface of the substrate holder 212 placed at the predetermined position in the vacuum chamber 220. The air in the film forming space B was evacuated by opening the vacuum valve 219′ to bring the space to a vacuum of about 1.33 x 10⁻³ Pa (10⁻⁵ Torr). Then, the heater 213 was actuated to heat uniformly the glass plate (substrate) 218 to 200°C, and the plate was maintained at this temperature.

In parallel, SiH₄ gas from the reservoir 201 and NH₃ gas from the reservoir 202 were fed into the reaction region B′ through the gas supplying conduit 209 respectively at a flow rate of 5 x 10⁻⁷ m³ S⁻¹ (30 SCCM). At the same time, F₂ gas from the reservoir 206 and He gas from the reservoir 207 were fed into the reaction region respectively at a flow rate of 8.3 x 10⁻⁸ m³ S⁻¹ (5 SCCM) and at a flow rate of 7.5 x 10⁻⁷ m³ S⁻¹ (45 SCCM) through the gas supplying conduit 211.

After the flow amount of the gases became stable, the vacuum in the vacuum chamber 220 was brought to and maintained at about 133.3 Pa (1.0 Torr) by regulating the vacuum valve 219′. Wherein, there was observed a strong blue luminescence throughout the reaction region B′ namely all over the confluent part of the gas from the gas supplying conduit 209 and the gas from the gas supplying conduit 211 and the surface of the glass plate 218.

After 3 minutes, it was found that an a-SiN:H:F film of about 0.1 »m (1000 Å) in thickness was uniformly on the glass plate 218.

Then, the feeding of NH₃ gas was stopped by closing the main valve 202d and the sub-valve 202e on the pipe way 202a, the feedings of SiH₄ gas, F₂ gas and He gas were continued respectively at a flow rate of 5 x 10⁻⁷ m³ S⁻¹, 8.3 x 10⁻⁸ m³ S⁻¹ and 7.5 x 10⁻⁷ m³ S⁻¹ (30 SCCM, 5 SCCM and 45 SCCM). After 1 hour, it was found that an a-Si:H:F layer of about 1.0 »m in thickness was uniformly formed on the former a-SiN:H:F layer.

Further successively, while a gas containing 5000 ppm of PH₃ in He gas (hereinafter referred to as "PH₃/He gas") from the reservoir 203 being fed at a flow rate of 1 x 10⁻⁷ m³ S⁻¹ (6 SCCM) into the reaction region B′, the feedings of SiH₄ gas, F₂ gas and He gas were continued respectively at a flow rate of 5 x 10⁻⁷ m³ S⁻¹, 8.3 x 10⁻⁸ m³ S⁻¹ and 7.5 x 10⁻⁷ m³ S⁻¹ (30 SCCM, 5 SCCM and 45 SCCM). After one minute, it was found that an n-type a-Si:H:F:P layer of about 0.3 »m (3000 Å) in thickness was uniformly formed on said a-Si:H:F layer.

The feedings of all the gases was terminated by closing the corresponding valves, the heater was switched off, and the vacuum atmosphere in the vacuum chamber was released to atmospheric pressure by opening the vacuum valve 219′.

After the glass plate 218 being cooled to room temperature, it was taken out from the vacuum chamber 220. Then the glass plate was placed in another vacuum chamber (not shown) and a comb line Al electrode of about 0.05 »m (500 Å) in thickness, 2.5 cm in gap length and 0.2 mm in gap interval was formed on the surface of the film deposited on the glass plate in accordance with the known vacuum deposition method to obtain an objective image-reading photosensor.

The characteristics of the resulting image-reading photosensors were examined in accordance with the same procedures as in Example 1, wherein light irradiation was conducted from the side of the glass plate.

As a result, it was found that the ratio of electric current under light irradiation to electric current under a dark condition was 1 x 10^{4.0}. There was no change in this numerical value, even after light irradiation for 24 hours.

## Claims

1. A process of preparing an image-reading photosensor having a substrate (101) an insulating film (104), a photoelectric conversion layer (102) comprising a film composed of a non-single crystalline semiconductor material, an ohmic contact film (105) and an electrode (103) electrically connected to the photoelectric conversion layer (102) via said ohmic contact film (105), wherein each of said films is formed by:
(a) supporting said substrate (101, 218) at a predetermined position in a film-forming space (B) of a CVD vacuum chamber (220) provided with a plurality of gas transportation conduits (209, 210, 211), wherein said gas transportation conduits (209, 210, 211) comprises concentrically arranged pipes, the ends of which are arranged at a position facing the surface of the substrate (218) at a distance of between 5 mm and 15 cm,
(b) supplying a first gaseous substance through one of said plurality of gas transportation conduits into said film-forming space (B), said first gaseous substance, containing an element which is a constituent of the film, which is essentially incapable of contributing to the formation of said film in its original energy state,
(c) separately supplying a second gaseous substance through another of said plurality of gas transportation conduits into said film-forming space (B),said second gaseous substance being capable of oxidising said first gaseous substance and which comprises molecules selected from one or more of air, O₂, O₃, N₂O, N₂O₃, N₂O₄, H₂O₂, F₂, Cℓ₂, Br₂, I₂, nascent fluorine, nascent chlorine and nascent iodine, and
(d) chemically reacting said first and second gaseous substances in the absence of a plasma in a reaction region (B′) adjacent the surface of the substrate (218) while maintaining the substrate (218) at an elevated temperature, so that precursors are generated which include excited precursors and so that at least one of the precursors becomes deposited on the substrate (218) to form the film.

2. A process according to claim 1 wherein the first gaseous substance contains silicon atoms.

3. A process according to claim 2 wherein in forming said photoelectric conversion layer film (102) a gaseous compound containing either Group III or Group V constituent atoms is supplied separately through one of said plurality of gas transportation conduits.

4. A process according to any preceding claim wherein the chemical reaction between the first and second gaseous substances and the formation of each of said films are accompanied by an emission of luminescent radiation.

## Patentansprüche

1. Verfahren zur Herstellung eines Bildlesephotosensors, der ein Substrat (101), einen isolierenden Film (104), eine photoelektrische Umwandlungsschicht (102), die einen Film umfaßt, der aus einem nicht einkristallinen Halbleitermaterial zusammengesetzt ist, einen ohmschen Kontaktfilm (105) und eine Elektrode (103) aufweist, die elektrisch mit der photoelektrischen Umwandlungsschicht (102) über diesen ohmschen Kontaktfilm (105) verbunden ist, wobei diese Filme gebildet werden mittels:
(a) des Haltens dieses Substrats (101, 218) in einer vorbestimmten Position in einem filmbildenden Raum (B) einer CVD Vakuumkammer (220), die mit einer Vielzahl von Gasförderleitungen (209, 210, 211) versehen ist, wobei diese Gasförderleitungen (209, 210, 211) konzentrisch angeordnete Rohre aufweisen, wobei deren Enden in einer Position angeordnet sind, in der sie auf die Oberfläche des Substrats (218) in einer Entfernung von 5 mm bis 15 cm gerichtet sind,
(b) der Zuleitung einer ersten gasförmigen Substanz durch eine der Vielzahl der Gasförderleitungen in diesen filmbildenden Raum (B), wobei diese erste gasförmige Substanz ein Element enthält, das ein Bestandteil des Films ist, das im wesentlichen nicht in der Lage ist zur Bildung dieses Films in seinem ursprünglichen Energiezustand beizutragen,
(c) der getrennten Zuleitung einer zweiten gasförmigen Substanz durch eine andere von dieser Vielzahl an Gasförderleitungen in diesen filmbildenden Raum (B), wobei diese zweite gasförmige Substanz in der Lage ist diese erste gasförmige Substanz zu oxidieren und dies umfaßt ein oder mehrere Moleküle, die ausgewählt werden aus Luft, O₂, O₃, N₂O, N₂O₃, N₂O₄, H₂O₂, F₂, Cl₂, Br₂, J₂, naszierendem Fluor, naszierendem Chlor und naszierendem Jod und
(d) der chemischen Reaktion dieser ersten und zweiten gasförmigen Substanzen in der Abwesenheit eines Plasmas in einem Reaktionsbereich (B′), der an die Oberfläche des Substrats (218) grenzt, während das Substrat (218) bei einer erhöhten Temperatur gehalten wird, so daß Vorstufen gebildet werden, die angeregte Vorstufen einschliessen, so daß zumindest eine der Vorstufen auf dem Substrat (218) abgeschieden wird, um den Film zu bilden.

2. Ein Verfahren gemäß Anspruch 1, dadurch gekennzeichnet, daß die erste gasförmige Substanz Siliciumatome enthält.

3. Verfahren gemäß Anspruch 2, dadurch gekennzeichnet, daß bei der Bildung dieses photoelektrischen Umwandlungsschichtfilms (102) eine gasförmige Verbindung, die entweder Gruppe III oder Gruppe V Atomkomponenten enthält, getrennt durch eine der Vielzahl an Gasförderleitungen zugeleitet wird.

4. Verfahren gemäß jedem vorangehenden Anspruch, dadurch gekennzeichnet, daß die chemische Reaktion zwischen den ersten und zweiten gasförmigen Substanzen und die Bildung von jedem dieser Filme von der Emission einer lumineszenten Strahlung begleitet wird.

## Revendications

1. Procédé de fabrication d'un photodétecteur de lecture d'images comprenant un substrat (101), un film isolant (104), une couche (102) de conversion photoélectrique comprenant un film composé d'une matière semiconductrice non mono-cristalline, un film (105) de contact ohmique et une électrode (103) reliée électriquement à la couche (102) de conversion photoélectrique par l'intermédiaire du film (105) de contact ohmique, dans lequel chacun des films en question est formé par :
(a) support du substrat (101, 218) dans une position prédéterminée dans un espace (B) de formation de film d'une chambre à vide (220) de dépôt par voie chimique en phase vapeur pourvu d'une pluralité de conduits (209, 210, 211) de transport de gaz, ces conduits (209, 210, 211) de transport de gaz comprenant des tubes à disposition concentrique dont les extrémités sont agencées dans une position tournée vers la surface du substrat (218) à une distance comprise entre 5 mm et 15 cm,
(b) apport d'une première substance gazeuse par l'un des divers conduits de transport de gaz dans l'espace (B) de formation de film, cette première substance gazeuse contenant un élément qui est un constituant du film essentiellement incapable de contribuer à la formation de ce film dans son état initial d'énergie,
(c) apport séparé d'une seconde substance gazeuse par un autre de ses divers conduits de transport de gaz dans l'espace (B) de formation de film, cette seconde substance gazeuse étant capable d'oxyder la première substance gazeuse et comprenant une ou plusieurs molécules choisies entre l'air, O₂, O₃, N₂O, N₂O₃, N₂O₄, H₂O₂, F₂, Cℓ₂, Br₂, I₂, le fluor naissant, le chlore naissant et l'iode naissant, et
(d) réaction chimique des première et seconde substances gazeuses en l'absence d'un plasma dans une zone de réaction (B′) adjacente à la surface du substrat (218) en même temps que le substrat (218) est maintenu à une température élevée, de manière à engendrer des précurseurs qui comprennent des précurseurs excités et que l'un au moins des précurseurs se dépose sur le substrat (218) pour former le film.

2. Procédé suivant la revendication 1, dans lequel la première substance gazeuse contient des atomes de silicium.

3. Procédé suivant la revendication 2, dans lequel un composé gazeux contenant des atomes d'éléments du Groupe III ou du Groupe V est amené séparément au cours de la formation du film (102) de la couche de conversion photo-électrique par l'un des divers conduits de transport de gaz.

4. Procédé suivant l'une quelconque des revendications précédentes, dans lequel la réaction chimique entre les première et seconde substances gazeuses et la formation de chacun des films s'accompagnent de l'émission d'une radiation luminescente.
